(19) Europäisches Patentamt
European Patent Office
Office européen des brevets

(11) EP 0 905 879 B1

(12) **EUROPÄISCHE PATENTSCHRIFT**

(45) Veröffentlichungstag und Bekanntmachung des Hinweises auf die Patenterteilung:
**29.06.2005 Patentblatt 2005/26**

(51) Int Cl.⁷: **H03C 3/09**

(21) Anmeldenummer: **98116464.3**

(22) Anmeldetag: **01.09.1998**

(54) **Sender zum Erzeugen eines hochfrequenten Sendesignals**

Transmitter for generating a high frequency transmitter signal

Emetteur pour générer un signal d'émission haute fréquence

(84) Benannte Vertragsstaaten:
**DE FI FR GB SE**

(30) Priorität: **30.09.1997 DE 19743207**

(43) Veröffentlichungstag der Anmeldung:
**31.03.1999 Patentblatt 1999/13**

(73) Patentinhaber: **Infineon Technologies AG**
**81669 München (DE)**

(72) Erfinder: **Herzinger, Stefan**
**80686 München (DE)**

(74) Vertreter: **Epping Hermann & Fischer**
**Ridlerstrasse 55**
**80339 München (DE)**

(56) Entgegenhaltungen:
WO-A-95/16304           US-A- 5 128 633
US-A- 5 313 173         US-A- 5 434 887

**Beschreibung**

Die Erfindung betrifft einen Sender zum Erzeugen eines hochfrequenten Sendesignals, welcher beispielsweise in Mobilfunksystemen eingesetzt werden kann. Diese können unter anderem den weit verbreiteten GSM-Standard (Global System For Mobil Communication) oder den DCS1900-Standard benutzen. Die Erfindung ist jedoch nicht auf die explizit genannten Standards beschränkt, sondern kann für alle Kommunikationssysteme verwendet werden, bei denen die Modulation des Trägersignals derart erfolgt, daß dessen Amplitude konstant bleibt (Phasenmodulation).

Das GSM-Netz besteht, wie jedes andere Telekommunikationsnetz auch, aus Systembestandteilen, die Schnittstellen bedienen und Funktionalitäten bereitstellen. Es arbeitet in den Frequenzbereichen 890 MHz bis 915 MHz und 935 MHz bis 960 MHz. Das Netz ist aus einer Vielzahl von Funkstellen aufgebaut. Die Anzahl der modular einsetzbaren Grundbausteine im GSM-Netz ist jedoch verhältnismäßig gering. Das Base-Station-SubSystem (Basisstationsteilsystem) organisiert den sicheren Datenaustausch zwischen den Mobilstationen und der Netzinfrastruktur. Dazu gehören Aufbau, Aufrechterhaltung und Aufbau der Funkverbindung zwischen Mobilstationen und der Base-Tranceiver-Station (Basisstation). Darüber hinaus wird eine ständige Qualitätsbeurteilung des Funkkanals und die daraus abzuleitenden Reaktionen des Systems z.B. die Einleitung und Steuerung von Zellwechseln (Hand-Over) vorgenommen. Außerdem werden Informationen über den Aufenthaltsort der Mobilstationen an das Netz weitergegeben. Das vermittlungstechnische Teilsystem (Switching-Subsystem) führt zum einen alle Aufgaben aus, die zum Aufbau, Verwalten und Lösen von Verbindungen benötigt werden. Zum anderen muß das vermittlungstechnische Teilsystem aber auch alle mobilitätsbedingten Verfahren durchführen. Dies reicht von der Verwaltung der statischen Teilnehmerdaten über das Auffinden einer gerufenen Mobilstation an einem beliebigen Ort des GSM-Versorgungsbereichs bis zur zuverlässigen Erfassung aller Gebührendaten. Daneben bedient das vermittlungstechnische Teilsystem Schnittstellen zu anderen Telekommunikationsnetzen oder Telekommunikationsdiensten.

Die Funkstrecke zwischen dem Mobilteil und der Netzinfrastruktur ist von zwei Grundeigenschaften geprägt: Die Ressource Funkkanal ist nur eingeschränkt verfügbar. Sie kann prinzipiell an einem Ort zur selben Zeit nur einmal verwendet werden. Jeder Funkkanal ist hochgradig störanfällig. Das Auftreten von Störungen in diesen offenen Systemen kann nicht unterbunden werden. Auf einem physikalischen Funkkanal werden zeitgeteilt acht physikalische Nachrichtenkanäle, genannt Bursts, übertragen. Eine vollständige Sequenz aller acht Kanäle wird TDMA-Rahmen (Time-Devision-Multible-Access) genannt. Auf jedem physikalischen Nachrichtenkanal können Signalisierungs- und/oder Nutzinformationen auf sogenannten logischen Kanälen vermittelt werden. Die Zuordnung von logischen auf physikalische Kanäle wird als Mapping bezeichnet. Das Mapping ist dynamisch und wechselt in Abhängigkeit von Betriebszustand und zu realisierender Übertragungsaufgabe, z.B. bei der Übertragung von Sprachinformationen über den Normalburst bei bestehender Telefonverbindung. Die logischen Kanäle bestehen aus den Verkehrskanälen und den Steuer- oder Kontrollkanälen.

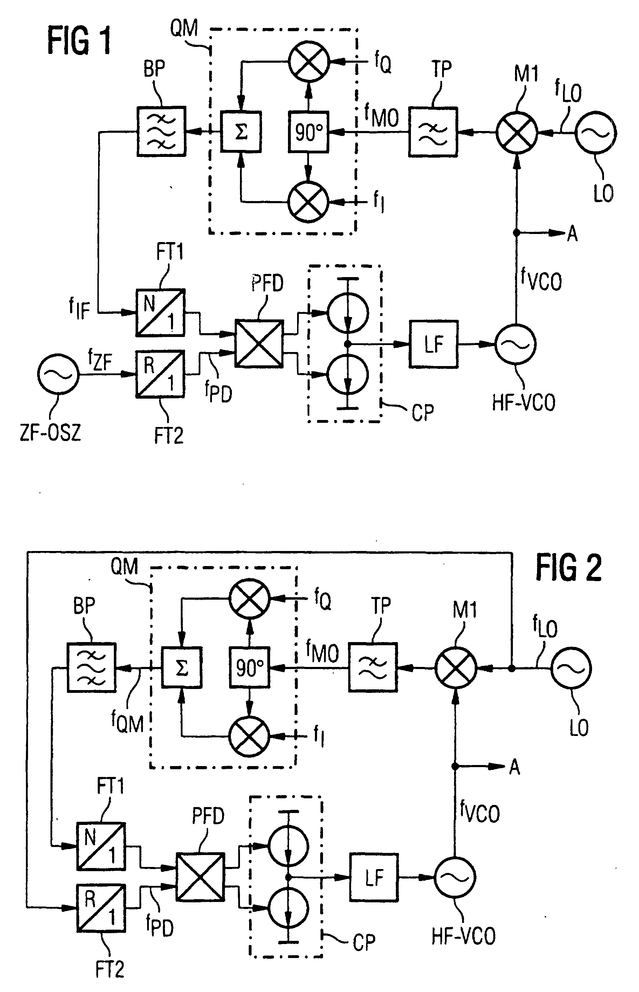

Um das Signal über die Luftschnittstelle zu übertragen, ist ein Sender notwendig, der das Datensignal im Basisband so aufbereitet, daß es über die Luftschnittstelle übertragbar ist. Dabei dürfen keine Konflikte mit anderen zu übertragenden Informationen, die von anderen Funksystemen stammen, entstehen. Eine Voraussetzung für eine gute Sendesignalqualität ist ein niedriger Rauschpegel weitab vom Träger bei hoher Sendeleistung. Dazu ist aus dem Stand der Technik ein in Figur 1 gezeigter Sender bekannt (siehe auch Datenblatt Telefunken vom 29. Januar 1997: Modulation PLL for GSM, DCS and PCS Systems U2893B, Application circuit (900 MHz)). Dieser weist einen lokalen Oszillator LO, der zur Kanaleinstellung dient, auf. Das vom lokalen Oszillator LO stammende Signal mit der Frequenz fLO wird mit einem Sendesignal der Frequenz fVCO, welches von einem Hochfrequenzoszillator HF-VCO stammt mittels eines Mischers M1 gemischt und einem Tiefpaß TP zugeführt. Das am Ausgang des Tiefpasses TP anliegende anliegende Modulatoreingangssignal mit der Frequenz fMO wird auf einen Quadraturmodulator QM geführt, der das Inphase-Datensignal mit der Frequenz fl und das Quadratur-Datensignal mit der Frequenz fQ jeweils mit dem Modulatoreingangssignal (Frequenz fMO) mischt und die entsprechenden Mischerausgangssignale addiert. Das so gewonnene quadraturmodulierte Signal wird durch den Bandpaß BP gefiltert und einem ersten Frequenzteiler FT1 mit dem Teilerverhältnis N zugeführt. Der erste Frequenzteiler FT1 teilt das Signal mit der Frequenz fIF durch den Teilerwert N und führt das geteilte Signal auf einen Phasenfrequenzvergleicher PFD. Das von einem Zwischenfrequenzoszillator ZF-OSZ stammende Signal mit der Frequenz fZF wird einem zweiten Frequenzteiler FT2 mit dem Teilerwert R zugeführt, welcher die Frequenz fZF durch den Teilerwert R teilt und dem Phasenfrequenzvergleicher PFD zuführt. Dieser vergleicht anfänglich die an dessen Eingängen anliegenden Frequenzen und später deren Phasen miteinander. Der Phasenfrequenzvergleicher PFD erzeugt entsprechende Steuerausgangssignale, üblicherweise in Form von Nadelimpulsen, welche einer Ladungspumpe CP zugeführt werden. Die Ladungspumpe CP in Verbindung mit einem passiven Schleifenfilter LF wirkt wie ein aktives Schleifenfilter. Das am Ausgang des Schleifenfilters LF anliegende Signal steuert den Hochfrequenzoszillator HF-VCO, welcher dann direkt das Sendesignal mit der Frequenz fVCO erzeugt, das am Ausgang A des Senders abgreifbar ist.

Die beschriebene Schaltung hat zwei gravierende Nachteile. Erstens weist das vom Mischer M1 erzeugte Signal einen hohen Störsignalanteil auf, weil sowohl der Hochfrequenzoszillator HF-VCO, als auch der Lokaloszillator LO einen nicht unerheblichen Klirrfaktor aufweisen, d.h. sie erzeugen Signale mit einer Grundfrequenz und mehreren Harmonischen dazu. Zusätzlich wird beim Wechseln der Frequenz fLO von einer ersten auf eine zweite Kanalfrequenz ein gegenüber dem ersten Mischprodukt verschiedenes Mischprodukt entstehen, was bedeutet, daß am Mischerausgang neue, veränderte Störsignalanteile auftreten. Die Frequenzen der Störsignalanteile können zudem sehr nahe bei der Sendefrequenz fVCO liegen. Zweitens können Störungen vom Phasenfrequenzvergleicher PFD ausgehen, wobei diese frequenzmäßig ebenfalls in der Näher der Sendefrequenz fVCO liegen können.

Eine Aufgabe der Erfindung ist es, einen Sender anzugeben, bei dem die im Stand der Technik auftretenden Störungen vermieden werden.

Die Aufgabe wird durch einen Sender gemäß Patentanspruch 1 gelöst.

Der erfindungsgemäße Sender zum Erzeugen eines hochfrequenten Signals weist einen ersten Oszillator, einen Mischer, einen Quadraturmodulator, mindestens einen Frequenzteiler, einen Vergleicher, ein erstes Filter und einen zweiten Oszillator auf. Der Ausgang des ersten Oszillators ist mit dem ersten Eingang des Mischers und dem ersten Eingang des Vergleichers verbunden. Der Ausgang des Mischers ist mit dem ersten Eingang des Quadraturmodulators verbunden. Am zweiten und dritten Eingang des Quadraturmodulators liegen Basisband-Eingangssignale an. Der Ausgang des Quadraturmodulators ist mit dem zweiten Eingang des Vergleichers und der Ausgang des Vergleichers mit dem Eingang des ersten Filters und der Ausgang des ersten Filters mit dem Eingang des zweiten Oszillators verbunden. Der zweite Eingang des Mischers ist mit dem Ausgang des zweiten Oszillators, an dem auch das hochfrequente Sendesignal anliegt, verbunden. Zwischen den ersten Oszillator und den Vergleicher und/oder zwischen den Quadraturmodulator und den Vergleicher ist der Frequenzteiler geschaltet.

Vorteilhafterweise wird für die erfindungsgemäße Schaltung weniger Chipfläche benötigt. Ein weiterer Vorteil besteht darin, daß durch die starre Frequenzkopplung, unabhängig von der Kanalfrequenz, eine eventuell auftretende Störung immer exakt mit der Sendefrequenz zusammenfällt, was dann unproblematisch ist.

Vorteilhafte Weiterbildungen ergeben sich aus den abhängigen Ansprüchen.

So ist in einer Ausführungsform ein zweites Filter vorgesehen, das zwischen den Mischer und den Quadraturmodulator geschaltet ist.

Weiterhin kann eine Ladungspumpe vorgesehen sein, die dem ersten Filter vorgeschaltet ist.

Der Vergleicher kann auch zum Frequenzvergleich dienen.

Es kann ein drittes Filter vorgesehen sein, das zwischen den Quadraturmodulator und den Vergleicher geschaltet ist.

Der Sender ist für ein Mobilfunksystem verwendbar.

Die Erfindung wird im folgenden anhand von zwei Figuren weiter erläutert.

Figur 1 zeigt einen Sender wie er aus dem Stand der Technik bekannt ist.

Figur 2 zeigt das Blockschaltbild eines erfindungsgemäßen Senders.

Auf Figur 1 wurde bereits oben eingegangen.

Gegenüber dem in Figur 1 gezeigten Blockschaltbild wurde bei dem in Figur 2 gezeigten Sender erstens der Zwischenfrequenzoszillator ZF-OSZ entfernt und zweitens der lokale Oszillator LO zusätzlich mit dem Eingang des zweiten Frequenzteilers FT2 verbunden. Der Begriff "verbunden" bedeutet im gesamten Kontext, daß die einzelnen Schaltungselemente entweder direkt oder aber unter Zwischenschaltung eines oder mehrerer weiterer Schaltungselemente mit dem zweiten Schaltungselement verknüpft sind. Der Begriff "verbunden" soll sowohl eine funktionelle als auch eine physikalische Verbindung zwischen den einzelnen Schaltungselementen umfassen.

Der erfindungsgemäße Sender für Zellularsysteme erreicht mit geringem Schaltungsaufwand und bei geringem Stromverbrauch ein geringeres Breitband-Ausgangsrauschen, erzeugt wenigere unerwünschte Ausgangssignalanteile (z.B. durch unerwünschte Mischprodukte) und die Ausgangsphase folgt genauer dem gewünschten Modulationsschema als der Sender gemäß dem Stand der Technik (Figur 1).

Gegenüber dem in Figur 1 gezeigten Sender, bei dem sich die Ausgangsfrequenz fVCO und die Frequenz fLO in gleichem Maße ändern, also der lokale Oszillator im Kanalraster (200 KHz für GSM) liegt, ändert sich die Frequenz fVCO gegenüber der Frequenz fLO gemäß:

$$fVCO = fLO \cdot (R-N):R$$

Daraus ergeben sich folgende Konsequenzen, wenn der lokale Oszillator über einem bestimmten Bereich abgestimmt wird, um das Sende-Band abzudekken:

Die Frequenz fMO ist nicht konstant, sondern ändert sich abhängig von der Frequenz fLO gewichtet mit dem Faktor N:R.

Die Phasenvergleichsfrequenz fPD verstimmt sich ebenfalls in Abhängigkeit von der Frequenz fLO.

Das Frequenzraster des lokalen Oszillators Lo wird mit einem Faktor (R-N):R in das Kanalraster des Hochfrequenzoszillators HF-VCO übersetzt.

Der entscheidende Vorteil durch diese phasenstarre Verkopplung aller in der Schaltung vorkommenden Frequenzen liegt in der Vermeidung der Störsignalanteile (Spurious-Frequenzen). Beim Stand der Technik gemäß Figur 1 entstehen Spurious-Frequenzen wie folgt. Um eine hohe Phasengenauigkeit zu erreichen, muß der Phasenfrequenzdetektor PFD in der Lage sein, sehr kleine Phasenunterschiede linear zu verarbeiten. Da in der Schaltung gemäß Figur 1 ein digital arbeitender PhasenFrequenzdetektor PFD mit Ladungspumpe CP verwendet wird, bedeutet dies, daß sehr kurze Nadelimpulse mit der Phasenvergleichsfrequenz fPD erzeugt werden müssen. Auch bei der 0/90°-Erzeugung im Quadraturmodulator QM bedient man sich digitaler Techniken (Flip-Flops), die sehr steile Schaltflanken erzeugen.

Als Konsequenz derartiger Signalverarbeitung entstehen spektral gesehen immer die Obertonspektren dieser Frequenzen (Phasenvergleichsfrequenz fPD, Quadraturmodulatorfrequenz fQM). Aufgrund systemtechnischer Vorgaben sind diese Schaltungselemente sehr schnell auszulegen (Phasengenauigkeit, sowohl beim Quadraturmodulator QM, als auch beim Phasenfrequenzdetektor PFD). Dies ist gleichbedeutend, daß die Obertonspektren bis zu sehr hohen Frequenzen (mehrere GHz) relativ hohen Energieinhalt haben.

Das bei diesen Frequenzen erfolgende Übersprechen auf andere Schaltungsteile führt zu folgendem Effekt:

Vielfache der Phasenvergleichsfrequenz fPD oder Quadraturmodulatorfrequenz fQM werden mit Vielfachen der Frequenz fLO im Mischer M1 in die Nähe der Frequenz fQM umgesetzt. Je näher dieses unerwünschte Mischprodukt an die Frequenz fQM, und damit an der Sendefrequenz fVCO liegt, desto weniger wird es durch die Übertragungsfunktion des Regelkreises unterdrückt. Beim Überstreichen des Frequenzbandes des lokalen Oszillators LO finden sich immer Frequenzen, bei denen das unerwünschte Produkt sehr nahe am gewünschten Träger liegt, also beispielsweise einen Kanalabstand entfernt. Ein derartiges Störprodukt erreicht mit sehr hohem Leistungspegel den Ausgang A und ist mit keiner bisher bekannten Filterung unterdrückbar, da das Störprodukt bereits innerhalb des modulierenden Ausgangsspektrums liegt und damit mit hoher Wahrscheinlich die System-Spezifikation verletzt wird.

Am folgenden Beispiel für GSM wird gezeigt, daß Störprodukte höherer Ordnung nie zu vermeiden sind:

Wählt man z.B. die ZF-Frequenz fZF bei 246 Mhz und die Phasenvergleichsfrequenz fPD bei 123 MHz, so ergibt sich für das GSM-Sendeband 890-915 MHz das notwendige Frequenzband des lokalen Oszillators LO bei 1136-1161 MHz. Am Mischer M1 entstehen die Harmonischen vom lokalen Oszillator LO, da der Mischer M1 aus Effizienz-Gründen im Schaltbetrieb arbeitet. So kommt 3fLO im Band 3408-3483 MHz zu liegen (der 3. Harmonischen kommt aufgrund der schaltungstechnischen Realisierung die höchste Amplitude zu). Gleichzeitig ist im Mischer M1 aufgrund der Übersprecheffekte ein Signal bei 26fPD=3198 MHz vorhanden. Stimmt man den lokalen Oszillator LO nun z.B. auf 1147,8 MHz (ein GSM-Kanal neben (3198+246)/3 MHz), so entsteht außer dem erwünschten ZF-Träger bei 246 MHz auch noch das Mischprodukt bei 3*1147.8MHz-26*123MHz=245.4MHz. Da die Mischung ein nichtlinearer Effekt ist, ist das ganze Obertonspektrum des 600 kHz Differenztones um den ZF-Träger gruppiert zu finden.

Bei geeigneter Wahl der Zwischenfrequenz ZF kann man den Effekt mit 3fLO zwar auf ein kleines Maß reduzieren: Das überstrichene 3fLO-Band muß dazu "zwischen" den Harmonischen der Phasenvergleichsfrequenz fPD zu liegen kommen. Bei einem für GSM nötigen Abstimmbereich von 25 MHz, einem 3fLO-Bereich von 75 MHz und einer Phasenvergleichsfrequenz fPD von hier 123 MHz läßt sich das 3fLO-Band noch mit einem Frequenzabstand von jeweils (123-75)/2 MHz = 24 MHz zwischen den fPD-Harmonischen zentrieren, für höhere fLO-Harmonische ist dies jedoch nicht mehr möglich.

Die Phasenvergleichsfrequenz fPD kann schon aus technologischen Gründen nicht mehr zu sehr erhöht werden.

Es ist jedoch anzumerken, daß auch bei solch einem bezüglich 3fLO optimierten Frequenzplan ein Differenzton prinzipiell entsteht. Dieser wird durch das Schleifenfilter LF jedoch stark unterdrückt. Andererseits steigen aber die Anforderungen der Systemspezifikation mit steigender Ablagefrequenz vom Träger stark an, womit auch ein derartiger "weitabspurious" zu einer Spezifikations-Verletzung führen kann.

Die neue Architektur vermeidet die Entstehung dieser Differenztöne schon im Ansatz vollständig.

Kennzeichnend für die neue Architektur ist die Tatsache, daß alle vorkommenden Frequenzen in festem harmonischem Verhältnis zueinander stehen (die Verknüpfungsfaktoren wurden bereits erläutert).

Dadurch fallen die Obertonmischprodukte genau (phasenstarr) in den Träger. Aufgrund der ungleichen Amplituden von Träger und Obertonmischprodukt hat dies praktisch keinen Einfluß auf den Träger. Es ist somit keine Entstehung von Differenztönen möglich.

Der einzige Mechanismus zur Entstehung von unerwünschten Frequenzanteilen ist die Übertragung der Phasenvergleichsfrequenz fPD in das Ausgangssignal. Diese liegt jedoch recht hoch(typ.100MHz) und wird bereits durch das Schleifenfilter LF (loop-filter) sehr stark unterdrückt. Bei dieser hohen Frequenzablage besteht die Möglichkeit, (wenn überhaupt nötig), mit Filterung des Sendesignals das Ausgangsspektrum noch zu verbessern.

Die Verwendung von zwei Teilern FT1 und FT2 mit den Teilerwerten N bzw. R, die verschieden oder auch gleich sein können, erreicht man einen höheren Freiheitsgrad bei der Bestimmung des Frequenzplans.

Der Schaltung liegt ein Upconversion-PLL-Konzept zugrunde.

Falls der Zwischenfrequenzoszillator ZF-OSZ für den Empfänger benötigt wird, hat die erfindungsgemäße Schaltungsanordnung den Vorteil, daß für den Sendevorgang -da dieser den Zwischenfrequenzoszillator nicht benötigt- der Stromverbrauch im System (Sender+Empfänger) reduziert werden kann.

Der Hochfrequenzoszillator HF-VCO ist ein spannungsgesteuerter Oszillator. Der lokale Oszillator LO kann ebenfalls ein spannungsgesteuerter Oszillator sein.

## Patentansprüche

1. Sender zum Erzeugen eines hochfrequenten Sendesignals,

   bei dem ein erster Oszillator (LO), ein Mischer (M1), ein Quadraturmodulator (QM), mindestens ein Frequenzteiler (FT1, FT2), ein Vergleicher (PFD), ein erstes Filter (LF) und ein zweiter Oszillator (HF-VCO) vorgesehen sind,
   bei dem der Ausgang des ersten Oszillators (LO) mit dem ersten Eingang des Mischers (M1) und dem ersten Eingang des Vergleichers (PFD) verbunden ist,
   bei dem der Ausgang des Mischers (M1) mit dem ersten Eingang des Quadraturmodulators (QM) verbunden ist,
   bei dem am zweiten und dritten Eingang des Quadraturmodulators (QM) Basisband-Eingangssignale anliegen,
   bei dem der Ausgang des Quadraturmodulators (QM) mit dem zweiten Eingang des Vergleichers (PFD) verbunden ist,
   bei dem der Ausgang des Vergleichers (PFD) mit dem Eingang des ersten Filters (LF) verbunden ist,
   bei dem der Ausgang des ersten Filters (LF) mit dem Eingang des zweiten Oszillators (HF-VCO) verbunden ist,
   bei dem der zweite Eingang des Mischers (M1) mit dem Ausgang des zweiten Oszillators (HF-VCO), an dem auch das hochfrequente Sendesignal anliegt, verbunden ist,
   bei dem zwischen den ersten Oszillator (LO) und den Vergleicher (PFD) oder/und zwischen den Quadraturmodulator (QM) und den Vergleicher (PDF) der Frequenzteiler (FT1, FT2) geschaltet ist.

2. Sender nach Anspruch 1,

   bei dem ein zweites Filter (TP) vorgesehen ist, das zwischen den Mischer (M1) und den Quadraturmodulator (QM) geschaltet ist.

3. Sender nach einem der Ansprüche 1 oder 2,

   bei dem eine Ladungspumpe (CP) vorgesehen ist, die dem ersten Filter (LF) vorgeschaltet ist.

4. Sender nach einem der Ansprüche 1 bis 3,

   bei dem der Vergleicher (PFD) auch zum Frequenzvergleich dient.

5. Sender nach einem der Ansprüche 1 bis 4,

   bei dem ein drittes Filter (BP) vorgesehen ist, das zwischen den Quadraturmodulator (QM) und den Vergleicher (PFD) geschaltet ist.

6. Verwendung des Senders nach einem der Ansprüche 1 bis 5, für ein Mobilfunksystem.

## Claims

1. Transmitter for production of a radio-frequency transmission signal,
   in which a first oscillator (LO), a mixer (M1), a quadrature modulator (QM), at least one frequency divider (FT1, FT2), a comparator (PFD), a first filter (LF) and a second oscillator (RF-VCO) are provided,
   in which the output of the first oscillator (LO) is connected to the first input of the mixer (M1) and to the first input of the comparator (PFD),
   in which the output of the mixer (M1) is connected to the first input of the quadrature modulator (QM),
   in which baseband input signals are applied to the second and the third input of the quadrature modulator (QM),
   in which the output of the quadrature modulator (QM) is connected to the second input of the comparator (PFD),
   in which the output of the comparator (PFD) is connected to the input of the first filter (LF),
   in which the output of the first filter (LF) is connected to the input of the second oscillator (RF-VCO),
   in which the second input of the mixer (M1) is connected to the output of the second oscillator (RF-VCO), at which the radio-frequency transmission signal is also produced,
   in which the frequency divider (FT1, FT2) is connected between the first oscillator (LO) and the comparator (PFD), and/or between the quadrature modulator (QM) and the comparator (PDF).

2. Transmitter according to Claim 1,

in which a second filter (TP) is provided, and is connected between the mixer (M1) and the quadrature modulator (QM).

3. Transmitter according to one of Claims 1 or 2, in which a charge pump (CP) is provided, and is connected upstream of the first filter (LF).

4. Transmitter according to one of Claims 1 to 3, in which the comparator (PFD) is also used for frequency comparison.

5. Transmitter according to one of Claims 1 to 4, in which a third filter (BP) is provided, and is connected between the quadrature modulator (QM) and the comparator (PFD).

6. Use of the transmitter according to one of Claims 1 to 5, for a mobile radio system.

**Revendications**

1. Émetteur de production d'un signal d'émission en haute fréquence, dans lequel il est prévu un premier oscillateur(LO), un mélangeur (M1), un modulateur (QM) en quadrature, au moins un diviseur (FT1, FT2) de fréquence, un comparateur (PFD) un premier filtre (LF) et un deuxième oscillateur (HF-VCO),

dans lequel la sortie du premier oscillateur (LO) est reliée à la première entrée du mélangeur (M1) et à la première entrée du comparateur (PFD),

dans lequel la sortie du mélangeur (M1) est reliée à la première entrée du modulateur (QM) en quadrature,

dans lequel des signaux d'entrée de bande de base s'appliquent à la deuxième et à la troisième entrées du modulateur (QM) en quadrature,

dans lequel la sortie du modulateur (QM) en quadrature est reliée à la deuxième entrée du comparateur (PFD),

dans lequel la sortie du comparateur (PFD) est reliée à l'entrée du premier filtre (LF),

dans lequel la sortie du premier filtre (LF) est reliée à l'entrée du deuxième oscillateur (HF-VCO),

dans lequel la deuxième entrée du mélangeur (M1) est reliée à la sortie du deuxième oscillateur (HF-VCO) à laquelle s'applique aussi le signal d'émission en haute fréquence,

dans lequel le diviseur (FT1, FT2) de fréquence est monté entre le premier oscillateur (LO) et le comparateur (PFD) ou/et entre le modulateur (QM) en quadrature et le comparateur (PDF).

2. Émetteur suivant la revendication 1, dans lequel il est prévu un deuxième filtre (TP) qui est monté entre le mélangeur (M1) et le modulateur (QM) en quadrature.

3. Émetteur suivant l'une des revendications 1 ou 2, dans lequel il est prévu une pompe (CP) de charge qui est montée en amont du premier filtre (LF).

4. Émetteur suivant l'une des revendications 1 à 3, dans lequel le comparateur (PFD) sert aussi à la comparaison des fréquences.

5. Émetteur suivant l'une des revendications 1 à 4, dans lequel il est prévu un troisième filtre (BP) qui est monté entre le modulateur (QM) en quadrature et le comparateur (PFD).

6. Utilisation de l'émetteur suivant l'une des revendications 1 à 5 pour un système de téléphonie mobile.

# FIG 1

# FIG 2